# EUROPEAN PATENT SPECIFICATION

(11) **EP 0 389 039 B1**
(45) Date of publication and mention of the grant of the patent: **12.06.1996**
(21) Application number: 90200605.5
(22) Date of filing: 14.03.1990
(51) Int. Cl.: H01L 23/485, G02F 1/13

(54) **Carrier body with elevated contact portions, a method of manufacturing such a carrier body and a display device comprising such a carrier body**
Trägerkörper mit vorspringenden Kontaktstellen, Verfahren zum Herstellen eines derartigen Trägerkörpers und Anzeigevorrichtung mit einem derartigen Trägerkörper
Support ayant des contacts surélevés, procédé de fabrication d'un tel support et dispositif d'affichage comprenant un tel support

(30) Priority: 20.03.1989 NL 8900675
(43) Date of publication of application: 26.09.1990
(73) Proprietor: Philips Electronics N.V., 5621 BA Eindhoven (NL); FASELEC A.G., Zürich 3 (CH)
(72) Inventor: Schraivogel, Rainer Ananda, NL-5656 AA Eindhoven (NL); Van Kessel, Cornelis Gerardus Maria, NL-5656 AA Eindhoven (NL); Bouwman,Jan, NL-5656 AA Eindhoven (NL)
(74) Representative: Raap, Adriaan Yde

(56) References cited:
- TOUTE L'ELECTRONIQUE, no. 534, May 1988, Paris FR, pp. 18-23; Y. LINUMA et al.: "Technique des écrans à cristaux liquides"
- PATENT ABSTRACTS OF JAPAN vol. 6, no. 151 (E-124)(1029) 11 August 1982 ; & JP-A-57 72 352
- SOLID STATE TECHNOLOGY, vol. 23, no. 3, March 1980, Washington US, pp. 71-76; T.S. LIU et al.: "A review of wafer bumping for tape automated bonding"
- IEEE INTERNATIONAL ELECTRONIC MANUFACTURING TECHNOLOGY SYMPOSIUM, 13 June 1988, Neuilly-sur-Seine FR, pp. 49-52; H.H. STECKHAN et al.: "TAB, a packaging approch for VLSI technology"

## Description

The invention relates to a carrier body comprising a conductor pattern at a major surface which conductor pattern is provided with elevated contact portions for making an electrical connection between said conductor pattern and an external environment.

The carrier body may comprise, for example a semiconductor substrate provided with an integrated circuit or a discrete semiconductor element or, for example a substrate of glass, quartz, a ceramic material, polyimide or a synthetic resin provided with a wiring pattern.

The invention also relates to a method of manufacturing such a carrier body and to a (display) device in which such a carrier body is used.

A carrier body of the type described in the opening paragraph provided with elevated contact portions, also referred to as "bumps", may be used for mounting by means of the so-called flip-chip method (also referred to as face-down bonding). A carrier body of this kind is described in US-A- 4,749,120. It comprises an IC provided with bumps and is mounted on a glass substrate by means of the said flip-chip method. In one of the mounting methods described in US-A-4,749,120 an electrically conducting contact is obtained between the bump and a conductor track by means of a pressure contact, whereafter the pressure of this contact is maintained by curing a resin layer provided between the substrate and the IC.

Such a mounting method is used, *inter alia* in the manufacture of display devices (LCDs) in which ICs are secured by means of the said flip-chip method on a substrate of glass or quartz which also forms part of the actual (liquid crystal) display device. Conductor tracks continuing as far as the actual display section are provided with drive voltages *via* the integrated circuits which contact these conductor tracks by means the said elevated contact portions(or bumps).

A carrier body and a method of manufacturing it according to the preambles of claims 1 and 3, respectively, are known from each of JP-A-57 72352 and Solid State Technology, vol. 23, no. 3, March 1980, pages 71-76.

However, a number of problems may occur. A first problem occurs, for example when contacting integrated circuits with many bumps, where different types of conductor tracks are present on the substrate, for example indiumtin oxide tracks for driving pixels in addition to, for example aluminium tracks. A possible difference in thickness between the different types of conductor tracks may give rise to poor or open contacts, notably in the case of pressure contacts.

Moreover, if no special measures are taken, the actual contact of a bump with, for example a thin connection conductor may remain limited to a very small area (for example, a projecting point of the bump), which leads to a high contact resistance.

The present invention has for its object to eliminate the above-mentioned drawbacks as much as possible.

It is based on the recognition that the contact resistance is decreased and that simultaneously the reliability of the bump contact can be enhanced by giving the bump a special Profile.

The object of the invention is met by a carrier body as defined in claim 1.

By forming a contact with the elevated contact portions of, for example gold, they are subjected to such a plastic deformation already at a low pressure that differences in the distance between the integrated circuit and the conductor tracks on the substrate are compensated for. The material of, the elevated contact portions and the conductor tracks on the substrate to be contacted can be chosen in such a way (for example, gold and indium tin oxide, respectively) that temperature changes hardly influence the reliability of the pressure contact.

In a preferred embodiment the elevated contact portions are substantially circular, hexagonal or octagonal shaped in plan view.

An advantage of the raised circumference (with respect to the central portion) is that a plurality of satisfactory electric contacts are obtained at the area of the circumference *via* the protrusions so that the said current concentration at one point is avoided and particularly the leakage resistance in thin layers is reduced. This advantage is notably achieved if the elevated contact portions, in a plan view, are circular, but good results are also achieved with regular or irregular polygons.

The thickness of the central portion is *e.g.* 1-5 µm, while the radii of curvature of the projections are *e.g.* approximately 1-3 µm.

Viewed in cross-section, the maximum height is preferably 10 µm in that case.

The structure may be manufactured by means of galvanization. A method of manufacturing a carrier body in which the carrier body is provided with a conductor pattern at a major surface comprising a number of bonding pads, said conductor pattern is covered by an insulating layer, the insulating layer is provided with contact windows at the area of said bonding pads and elevated contact portions are provided within said contact windows on said bonding pads by means of galvanization according to the invention is defined in claim 3.

The current density of the galvanization current is also dependent on the number of bumps to be manufactured and may typically lie in the range of 3-6mA/cm².

The structure as described above is obtained by means of such a method, notably in the case of circular bumps. Instead of circles, for example polygons are also possible.

The carrier body according to the invention is particularly suitable for substrates having connections arranged in a plurality of rows, as described in Application no. 90200606.3 simultaneously filed in the name of the Applicant.

The interconnection structure is notably advantageous in a display device in which connection electrodes extending beyond the display device on a (glass) supporting body are contacted, for example with an integrated circuit for drive purposes.

The invention will now be described in greater detail with reference to an embodiment and the accompanying drawing in which
Fig. 1 is a diagrammatic plan view of an elevated contact portion on a carrier body according to the invention;
Fig. 2 is a diagrammatic cross-section taken on the line II-II in Fig. 1;
Fig. 3 shows diagrammatically a carrier body according to the invention.

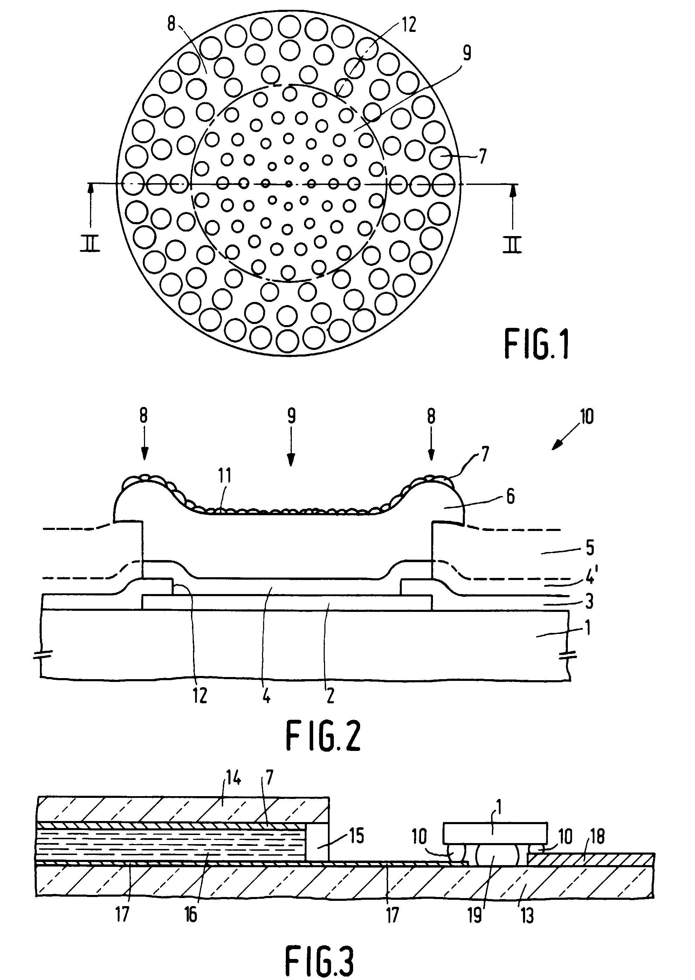

The elevated contact portion (bump) 10 of Fig. 1, 2 is present on a substrate 1, in this example an integrated circuit formed in silicon. The wiring pattern of the integrated circuit comprises, *inter alia* bonding pads 2 for contacting the circuit. The silicon substrate 1 has a passivating layer 3 of silicon oxide, silicon nitride or a combination thereof, which covers the entire surface area of the substrate 1, with the exception of the bonding pads 2. The passivating layer 3 has a thickness of approximately 1 µm and at the area of the bonding pads 2 it is provided with windows 12 having a slightly smaller surface area. In this example the bonding pads 2 are circular and have a diameter of approximately 70 µm, while the windows 12 have a diameter of approximately 60 µm.

The elevated contact portion has a double layer which comprises a first layer 4 of aluminium and a second layer 6 of gold with a total thickness of approximately 5 µm in this example. The thickness of the layer 4 is approximately 1 µm, while the thickness of the layer 6 is 2 µm in the central portion and approximately 3 µm along the edges. The gold layer 6 is provided on its entire surface area 11 with smooth spherical protrusions 7 having dimensions of 1-2 µm.

The elevated contact portion (bump) 10 described above can be manufactured as follows.

The method starts from a substrate 1 comprising an (integrated) circuit or another circuit element having bonding pads 2 and being coated with a passivating layer 10 having windows 12 at the area of the bonding pads. Firstly, a layer of aluminium 4 with a thickness of 1 µm is deposited on the whole assembly, which layer is used as a short-circuit layer at a later stage for obtaining the further structure by galvanization. The layer 4 may have an anti-diffusion coating to prevent gold from diffusing into the aluminium if gold is used for the layer 6.

Subsequently a mask 5 of a photoresist is provided photolithographically, which defines the areas where galvanization can take place. This layer has a thickness of, for example 2 µm, while the apertures in the mask 5 at the area of the bonding pads 2 have a diameter of approximately 70 µm.

Galvanization is performed in two steps. Firstly, a thin metal layer (in this example gold) is deposited to a thickness of approximately 1 µm at a low galvanization current and at a temperature of approximately 45°C. The layer thus obtained is in compliance with the underlying profile and is substantially smooth. Subsequently galvanization is continued with pulsed high currents. The current density then is 3-6 mA/cm² (dependent on the total number of bumps) for approximately 1 msec, whereafter a waiting time of 10 msec is observed for regeneration of the bath. During 5 galvanization an intense circulation is maintained in the galvanization bath. After galvanization the photoresist mask 5 and the subjacent part 4' of the aluminium layer 4 are removed.

An elevated contact portion according to Figs. 1, 2 having a circumference 8 which is raised with respect to the central portion 9 and with the surface 11 being provided with smooth spherical protrusions 7 is obtained in this manner, presumably by a combination of local field variations and the originally provided contours.

Fig. 3 shows a substrate 1 with, for example a control circuit which establishes an electrically conducting contact with conductor tracks 17, 18 on a supporting body 13 of, for example glass (or quartz) *via* such elevated contact portions 10 and by means of pressure contacts. Together with a sealing edge 15, the glass plate 13 and the second glass plate 14 enclose a liquid crystal material 16 and thus form a part of a liquid crystal display device. (Further components such as polarizers, lighting elements, etc. have been omitted for the sake of simplicity in Fig. 3).

To be able to drive the display device, it has connection electrodes which are formed by conductor tracks 17 of, for example indium tin oxide which extend beyond the edge 15 in this example and are connected in an electrically conducting manner to the control circuit in the substrate 1 *via* elevated contact portions (bumps) 10. External signals are applied to this control circuit *via* aluminium tracks 18 and elevated contact portions (bumps) 10. A possible difference in thickness between the conductor tracks 16 and 18 (exaggerated in Fig. 3) is compensated for, because the bumps 10 can be depressed over a large part of their thickness without any influence on the electric contact. The pressure for these pressure contacts is maintained in the relevant example by means of an adhesive bond 19.

The invention is of course not limited to the embodiment shown, but several variations are possible within the scope of the invention. For example, the bumps 10 may also be formed on the supporting body. Moreover, the elevated contact portions need not necessarily be circular or, for example hexagonal or octagonal, but the described structure may alternatively be obtained with the more conventional square bonding pads.

The passivating layer 3 may also have a larger thickness, for example if it is formed in polyimide. Moreover, variations of the layer structure 4, 6 (for example copper with a gold coating) are possible.

Various other applications are also possible. For example, in Fig. 3 the liquid crystal may be replaced by other electro-optical media such as electrochromic or electrophoretic materials.

More generally, the invention is applicable to chip-on-glass techniques, for example for memories or to face-down bonding techniques on ceramic material, polyimide, etc.

A carrier body with elevated contact portions according to the invention may also be used advantageously for control circuits for thin display devices as described in NL-A-8700486 (EP-A-0 288 095).

## Claims

1. A carrier body (1; 13) comprising a conductor pattern (2; 17, 18) at a major surface which conductor pattern is provided with elevated contact portions (10) for making an electrical connection between said conductor pattern and an external environment, said elevated contact portions having a central portion (9) and a circumference (8) which is raised in elevation with respect to the central portion, said conductor pattern being formed of an electrically conductive material which is liable to plastic deformation already at a low pressure, characterized in that said elevated contact portions are provided at their top surface and thereby at least at the surface of said raised circumference with a plurality of electrically conducting spherical protrusions (7) formed of an electrically conductive, plastically deformable material.

2. A carrier body as claimed in claim 1, characterized in that the elevated contact portions are substantially circular, hexagonal or octagonal shaped in plan view.

3. A method of manufacturing a carrier body as claimed in claim 1 or 2 in which the carrier body is provided with said conductor pattern at said major surface, said conductor pattern comprises a number of bonding pads (2) and is covered by an insulating layer (3), the insulating layer is provided with contact windows (12) at the area of said bonding pads and said elevated contact portions are provided within said contact windows on said bonding pads, characterized in that, in order to form the elevated contact portions, first a short-circuit layer (4, 4') is deposited over the bonding pads and the insulating layer, then, with the help of a photoresist mask (5) which has apertures at the area of the bonding pads, a base metal layer is formed using a substantially continuous galvanization current and thereafter the contact portions are completed using a pulsed galvanization current, and in that, after galvanization, the mask and the part (4') of the short-circuit layer outside the area of the bonding pads are removed.

4. A method as claimed in claim 3, characterized in that the base metal layer is grown to a thickness of at most 2 µm.

5. A method as claimed in claim 3 or 4, characterized in that a pulsed galvanization current density of 3-6 mA/cm² is applied.

6. A display device comprising an electro-optical medium between two supporting panels provided with drive electrodes in which the drive electrodes on one of the panels extend as far as beyond a surface area defined by said electro-optical medium, characterized in that either the display device or a semiconductor device constitutes the carrier body as claimed in claim 1 or 2 and in that the drive electrodes are electrically connected to the semiconductor device through elevated contact portions of the carrier body.

7. A display device as claimed in claim 6, characterized in that the electro-optical medium comprises a liquid crystal.

## Patentansprüche

1. Trägerkörper (1; 13) mit einem Leitermuster (2; 17, 18) auf einer Hauptfläche, wobei dieses Leitermuster mit vorspringenden Kontaktteilen (10) versehen ist zum elektrischen Kontaktieren des genannten Leitermusters mit einer äußeren Umgebung, wobei die genannten vorspringenden Teile einen zentralen Teil (9) und einen umgebenden Teil (8) aufweisen, der gegenüber dem zentralen Teil erhaben ist, wobei das genannte Leitermuster aus einem elektrisch leitenden Material gebildet ist, das bereits bei einem geringen Druck eine plastische Verformung erfahren kann, dadurch gekennzeichnet, daß die genannten erhabenen Teile an ihrer oberen Fläche und dadurch wenigstens an der Oberfläche des genannten erhabenen umgebenden Teils mit einer Anzahl elektrisch leitenden kugelförmigen, aus einem elektrisch leitenden, plastisch verformbaren Material gebildeten Vorsprüngen (7) versehen sind.

2. Trägerkörper nach Anspruch 1, dadurch gekennzeichnet, daß die erhabenen Kontaktteile in einer Ebene im wesentlichen kreisrund, hexagonal oder oktagonal sind.

3. Verfahren zum Herstellen eines Trägerkörpers nach Anspruch 1 oder 2, wobei dieser Trägerkörper mit dem genannten Leitermuster auf der genannten hauptfläche versehen wird, wobei das genannte Leitermuster eine Anzahl Anschlußflächen (2) aufweist und mit einer Isolierschicht (3) bedeckt wird, wobei die Isolierschicht in dem Gebiet der genannten Anschlußflächen mit Kontaktfenstem versehen (12) wird und wobei die genannten erhabenen Teile innerhalb der Kontaktfenster auf den genannten Anschlußflächen vorgesehen werden, dadurch gekennzeichnet, daß zum Bilden der erhabenen Kontaktteile zunächst eine Kurzschlußschicht (4, 4') über die Anschlußflächen und die Isolierschicht angebracht wird, daß danach mit Hilfe einer Photoresistmaske (5) mit Öffnungen im bereich der Anschlußflächen unter Anwendung eines im wesentlichen kontinuierlichen Galvanisierungsstromes eine Basismetallschicht gebildet wird, und daß daraufhin die Kontaktteile unter Anwendung eines pulsierenden Galvanisierungsstromes vervollständigt werden, und daß nach der Galvanisierung die Maske und der Teil (4') der Kurzschlußschicht außerhalb des Gebietes der Anschlußflächen entfernt werden.

4. Verfahren nach Anspruch 3, dadurch gekennzeichnet, daß die Basismetallschicht bis zu einer Dicke von höchstens 2 µm aufgewachsen wird.

5. Verfahren nach Anspruch 3 oder 4, dadurch gekennzeichnet, daß ein pulsierender Galvanisierungsstrom mit einer Dichte von 3-6 mA/cm² angelegt wird.

6. Wiedergabeanordnung mit einem elektrooptischen Medium zwischen zwei Trägerplatten mit Treiberelektroden, wobei die Treiberelektroden auf einer der Platten sich bis über einen durch das genannte elektrooptische Medium definierten Oberflächenbereich hinaus erstrecken dadurch gekennzeichnet, daß entweder die Wiedergabeanordnung oder eine Halbleiteranordnung den Trägerkörper nach Anspruch 1 oder 2 bildet, und daß die Treiberelektroden über erhabene Kontaktteile des Trägerkörpers mit der Halbleiteranordnung elektrisch verbunden sind.

7. Wiedergabeanordnung nach Anspruch 6, dadurch gekennzeichnet, daß das elektrooptische Medium ein Flüssigkristall aufweist.

## Revendications

1. Support (1; 13) comprenant une configuration de conducteurs (2; 17, 18) sur une surface principale, laquelle configuration de conducteurs est munie de contacts surélevés (10) pour établir une connexion électrique entre ladite configuration de conducteurs et un environnement extérieur, lesdits contacts surélevés ayant une partie centrale (9) et une circonférence (8) qui est surélevée par rapport à la partie centrale, ladite configuration de conducteurs étant formée d'un matériau conducteur d'électricité qui est apte à subir des déformations plastiques déjà à basse pression, caractérisé en ce que lesdits contacts surélevés sont munis à leur surface supérieure et de cette façon au moins à la surface de ladite circonférence surélevée d'une pluralité de protubérances sphériques conductrices de l'électricité (7) formées d'un matériau déformable plastiquement et conducteur de l'électricité.

2. Support selon la revendication 1, caractérisé en ce que les contacts surélevés sont pratiquement de forme circulaire, hexagonale ou octogonale dans une vue en plan.

3. Procédé de fabrication d'un support selon la revendication 1 ou 2, dans lesquels le support est muni de ladite configuration de conducteurs sur ladite surface principale, ladite configuration de conducteurs comprend un nombre de coussins de liaison (2) et est recouverte par une couche isolante (3), la couche isolante est munie de fenêtres de contact (12) au droit desdits coussins de liaison et lesdits contacts surélevés sont munis desdites fenêtres de contacts sur lesdits coussins de liaison, caractérisé en ce que, afin de former les contacts surélevés, une couche court-circuit (4, 4') est d'abord déposée sur les coussins de liaison et la couche isolante, puis, avec l'aide d'un masque photorésistant (5) qui a des ouvertures au droit des coussins de liaison, une couche en métal de base est formée en utilisant un courant de galvanisation pratiquement continu et ensuite les contacts sont achevés en utilisant un courant de galvanisation pulsé, et en ce que, après la galvanisation, le masque et la partie (4') de la couche court-circuit à l'extérieur de la zone des coussins de liaison sont enlevés.

4. Procédé selon la revendication 3, caractérisé en ce que la couche en métal de base est élevée jusqu'à une épaisseur d'au plus 2 µm.

5. Procédé selon la revendication 3 ou 4, caractérisé en ce qu'une densité de courant de galvanisation pulsé de 3-6 mA/cm² est appliquée.

6. Dispositif d'affichage comprenant un milieu électro-optique entre deux panneaux de support munis d'électrodes de commande, dans lequel les électrodes de commande sur un des panneaux s'étendent au-delà d'une zone de la surface définie par ledit milieu électro-optique, caractérisé en ce que le dispositif d'affichage ou un dispositif semiconducteur constitue le support selon la revendication 1 ou 2 et en ce que les électrodes de commande sont connectées électriquement au dispositif semiconducteur au moyen des contacts surélevés du support.

7. Dispositif d'affichage selon la revendication 6, caractérisé en ce que le milieu électro-optique comprend un cristal liquide.
